(19) Europäisches Patentamt

European Patent Office

Office européen des brevets

(11) **EP 4 468 732 A2**

(12) **DEMANDE DE BREVET EUROPEEN**

(43) Date de publication:
**27.11.2024 Bulletin 2024/48**

(21) Numéro de dépôt: **24176826.6**

(22) Date de dépôt: **20.05.2024**

(51) Classification Internationale des Brevets (IPC):
**H04Q 9/04** *(2006.01)* **G01R 19/25** *(2006.01)*
**G01R 31/08** *(2020.01)* **G01R 31/12** *(2020.01)*

(52) Classification Coopérative des Brevets (CPC):
**H04Q 9/04; G01R 19/2513; G01R 31/08;**
**G01R 31/1272;** G01R 31/12

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **23.05.2023 FR 2305072**

(71) Demandeur: **Nexans**
**92400 Courbevoie (FR)**

(72) Inventeurs:
- **KAFAL, Moussa**
  **91940 Les Ulis (FR)**
- **GRIOT, Samuel**
  **69007 Lyon (FR)**

(74) Mandataire: **Ipsilon**
**Le Centralis**
**63, avenue du Général Leclerc**
**92340 Bourg-la-Reine (FR)**

(54) **SYNCHRONISATION DE DISPOSITIFS D ACQUISITION DE DONNÉES D'UN SYSTÈME DE SURVEILLANCE EN LIGNE D'UN RÉSEAU DE DISTRIBUTION ÉLECTRIQUE**

(57) L'invention concerne la synchronisation entre au moins deux dispositifs d'acquisition de données d'un système de surveillance en ligne d'un réseau de distribution électrique, localisé chacun en un point connu du réseau et configuré pour détecter des événements haute fréquence lors de phases passives d'acquisition de données et pour injecter des signaux haute fréquence. Selon l'invention, on injecte dans le réseau un premier signal comprenant au moins une impulsion haute fréquence à partir d'un premier dispositif d'acquisition de données à un premier instant d'injection $t_{A1}$ horodaté par un premier moyen d'horodatage local; après réception du premier signal par le deuxième dispositif d'acquisition de données à un premier instant de réception $t_{B1}$ horodaté par un deuxième moyen d'horodatage local, on injecte dans le réseau un deuxième signal identique audit premier signal à partir du deuxième dispositif d'acquisition de données, le deuxième signal étant injecté à un deuxième instant d'injection $t_{B2}$ séparé du premier instant de réception $t_{B1}$ par une durée T prédéfinie ; sur réception du deuxième signal au niveau du premier dispositif d'acquisition de données à un deuxième instant de réception $t_{A2}$ horodaté par le premier moyen d'horodatage local, on détermine une différence de synchronisation entre le premier moyen d'horodatage local et le deuxième moyen d'horodatage local sur la base du premier instant d'injection $t_{A1}$, du deuxième instant de réception $t_{A2}$, et de la durée T prédéfinie.

EP 4 468 732 A2

**Description**

**Domaine technique**

La présente invention concerne le domaine général de la surveillance du bon fonctionnement des éléments présents dans un réseau de distribution électrique, notamment des câbles électriques, et plus précisément la synchronisation entre au moins deux dispositifs d'acquisition de données appartenant à un système de surveillance en ligne d'un réseau de distribution électrique.

**Arrière-plan technologique**

L'un des principaux problèmes susceptibles d'affecter le fonctionnement d'un réseau de transmission et/ou de distribution électrique est l'apparition de décharges partielles sur les câbles, les transformateurs, les appareillages de commutation, les jonctions de câbles, etc. qui peuvent conduire à leur dégradation progressive et, finalement, à des défauts destructeurs.

La détection et la localisation des décharges peuvent fournir des informations cruciales à l'opérateur de réseau concernant l'état de l'isolation des câbles de distribution en fonctionnement et de l'équipement en général.

Des systèmes de surveillance ont déjà été proposés sur la base de mesures à une extrémité d'un câble du réseau, qui utilisent la réflectométrie dans le domaine temporel (TDR) ainsi que des techniques de traitement des signaux. Toutefois, ces systèmes peuvent principalement être utilisés hors ligne et présentent des limites strictes en ce qui concerne leur efficacité et leur champ d'application.

D'autres systèmes connus, appelés systèmes de surveillance en ligne, peuvent détecter et localiser des évènements susceptibles de représenter des anomalies, de type décharge partielle, sans affecter le fonctionnement normal du réseau. Les informations relatives à la progression du phénomène dans le temps peuvent empêcher l'apparition de défauts destructeurs, améliorant ainsi les indices de fiabilité du réseau et évitant que le courant de court-circuit ne sollicite d'autres équipements. En conséquence, de tels systèmes de surveillance en ligne contribuent à l'un des aspects importants du réseau intelligent, à savoir l'utilisation optimale des actifs existants par la mise en oeuvre d'une maintenance préventive optimisée et d'une connaissance intelligente de l'état des actifs.

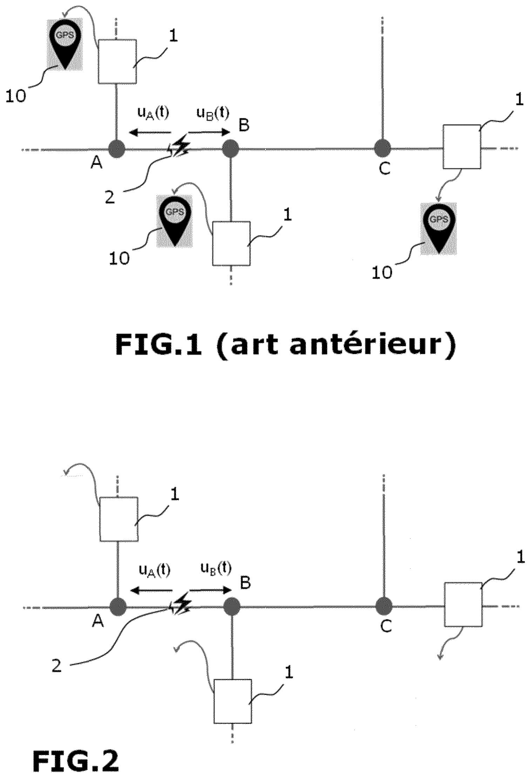

Comme représenté sur la figure 1, qui schématise partiellement un exemple de réseau de distribution électrique maillé, le principe de la surveillance en ligne consiste à placer une pluralité de dispositifs 1 d'acquisition de données en ligne à des emplacements prédéfinis du réseau, par exemple aux extrémités de câbles électriques présents dans ce réseau. Dans l'exemple non limitatif de la figure 1, trois de ces dispositifs 1 d'acquisition de données en ligne ont été représentés placés à trois localisations connues illustrées par les points A, B et C. Les deux dispositifs 1 placés aux points A et B peuvent détecter des évènements correspondant à une décharge partielle survenant à n'importe quelle position d'un câble ou équipement du réseau, par exemple située entre les points A et B ou même en dehors de ces points. De même, les deux dispositifs 1 placés aux points B et C peuvent détecter des évènements correspondant à une décharge partielle survenant à n'importe quelle position d'un câble ou équipement du réseau, par exemple située entre les points B et C, ou même en dehors de ces points.

Le principe connu de la localisation d'une décharge partielle avec ce type de systèmes de surveillance en ligne est le suivant : Si une décharge partielle 2 survient entre les points A et B du réseau, deux signaux impulsionnels correspondant $u_A(t)$ et $u_B(t)$ vont se propager en direction opposée dans le réseau. Le signal $u_A(t)$ est détecté par le dispositif 1 d'acquisition de données situé au point A à un instant $t_{oa_A}$, et le signal $u_B(t)$ est détecté par le dispositif 1 d'acquisition de données situé au point B à un instant $t_{oa_B}$. La localisation $Z_{PD}$ de la décharge partielle 2 peut ainsi être déterminée selon la relation suivante :

$$Z_{PD} = \frac{t_c - \Delta t_{oa}}{2t_c} \cdot l_c \quad (1)$$

avec

$$\Delta t_{oa} = t_{oa_A} - t_{oa_B} \quad (2)$$

$t_c$, le temps de vol entre les points A et B; et
$l_c$ la longueur connue de câble séparant les points A et B.

Afin de pouvoir déterminer la quantité $\Delta t_{oa}$, et par suite, la localisation $Z_{PD}$, il est donc nécessaire de synchroniser les deux dispositifs 1 d'acquisition de données situés aux points A et B. En d'autres termes, les instants d'arrivée $t_{oa_A}$ et $t_{oa_B}$ des signaux $u_A(t)$ et $u_B(t)$ acquis par chacun des deux dispositifs 1 d'acquisition de données doivent être déterminés dans un référentiel temporel commun.

Comme visible sur la figure 1, il est déjà connu d'associer chaque dispositif 1 d'acquisition de données du système de surveillance à un récepteur 10 d'un système de navigation par satellite, par exemple un récepteur GPS 10. Chaque évènement détecté par chacun des dispositifs 1 d'acquisition de données, par exemple le signal précédent $u_A(t)$ ou $u_B(t)$ généré par une décharge partielle, peut ainsi être horodaté dans un système de référence commun. Cette méthode de synchronisation est décrite par exemple dans le document WO 2021/138569. La différence entre les temps d'arrivée des signaux $u_A(t)$ et $u_B(t)$ au niveau des deux dispositifs 1 d'acquisition de données, exprimés dans une référence de temps commune, et par suite, la localisation $Z_{PD}$ de la décharge partielle, peuvent ensuite être déterminées par application des relations (1) et (2) ci-dessus.

Néanmoins, bien que la précision du GPS puisse être très élevée, plusieurs facteurs peuvent introduire des erreurs, tels que les effets de la propagation multiple du signal GPS, les erreurs de localisation des satellites, les conditions atmosphériques et, surtout, les difficultés d'installation. En effet, l'utilisation correcte des systèmes GPS implique l'utilisation d'antennes qui doivent être installées en espace libre pour permettre de capter le signal du satellite. Or, outre le fait que ces antennes sont coûteuses, de nombreux réseaux de distribution électrique haute tension ou moyenne tension sont des réseaux de distribution souterrains pour lesquels on souhaite minimiser les besoins d'installer des équipements en surface.

Une autre méthode connue, décrite dans le document WO 2004/013642 A2, consiste à injecter des impulsions de synchronisation haute fréquence à l'une des extrémités d'un câble sous surveillance d'un réseau de distribution, à l'aide d'un coupleur inductif. Les données acquises par les systèmes de surveillance utilisés aux deux extrémités du câble, générées par des impulsions de décharge partielle dans le câble contiennent ainsi à la fois des impulsions de décharge partielles et des impulsions de synchronisation. En alignant les ensembles de données et en utilisant le délai entre l'impulsion de décharge partielle et l'impulsion de synchronisation, il est possible d'obtenir l'emplacement de la décharge partielle. Cette méthode de synchronisation temporelle utilise le câble d'alimentation comme support de transmission des impulsions de synchronisation, ce qui atténue l'inconvénient de l'invisibilité des satellites et les problèmes de conditions atmosphériques associés au GPS. Cependant, la précision de cette méthode est fortement affectée par l'atténuation et la dispersion des impulsions de synchronisation se propageant dans le câble. Il en résulte une perte des données temporelles envoyées par le câble.

**Résumé de l'invention**

La présente invention a pour but de pallier les inconvénients des méthodes et systèmes pour synchroniser au moins deux dispositifs d'acquisition de données d'un système de surveillance en ligne d'un réseau de distribution électrique.

Plus précisément, la présente invention a pour objet un procédé de synchronisation entre au moins un premier dispositif et un deuxième dispositif d'acquisition de données d'un système de surveillance en ligne d'un réseau de distribution électrique, chaque dispositif d'acquisition de données étant localisé en un point connu du réseau et étant configuré pour détecter des évènements haute fréquence lors de phases passives d'acquisition de données et pour injecter des signaux haute fréquence, le procédé comportant les étapes suivantes :

- injecter dans le réseau un premier signal comprenant au moins une impulsion haute fréquence à partir du premier dispositif d'acquisition de données à un premier instant d'injection $t_{A1}$ horodaté par un premier moyen d'horodatage local ;

- recevoir ledit premier signal au niveau du deuxième dispositif d'acquisition de données à un premier instant de réception $t_{B1}$ horodaté par un deuxième moyen d'horodatage local ;

- injecter dans le réseau un deuxième signal identique audit premier signal à partir du deuxième dispositif d'acquisition de données, le deuxième signal étant injecté à un deuxième instant d'injection $t_{B2}$ horodaté par le deuxième moyen d'horodatage local et séparé du premier instant de réception $t_{B1}$ par une durée T prédéfinie ;

- recevoir ledit deuxième signal au niveau du premier dispositif d'acquisition de données à un deuxième instant de réception $t_{A2}$ horodaté par le premier moyen d'horodatage local ; et

- déterminer une différence de synchronisation $\Delta t_{oa}$ entre le premier moyen d'horodatage local et le deuxième moyen d'horodatage local sur la base du premier instant d'injection $t_{A1}$, du deuxième instant de réception $t_{A2}$, et de la durée T prédéfinie.

Dans un mode de réalisation possible, ladite durée T prédéfinie est supérieure à au moins une valeur estimée de temps de vol d'un signal entre le premier et le deuxième dispositifs d'acquisition de données.

Dans un mode de réalisation possible, ledit premier signal injecté et ledit deuxième signal injecté comprennent une séquence d'impulsions haute fréquence de période prédéfinie.

Dans un mode de réalisation possible, ladite durée T prédéfinie est supérieure à la somme de la valeur estimée de temps de vol et de ladite période prédéfinie.

Dans un mode de réalisation possible, la différence de synchronisation $\Delta t_{oa}$ est déterminée selon la relation suivante :

$$\Delta t_{oa} = t_{A2} + TOF'$$

dans laquelle TOF' correspond au temps de vol d'un signal entre le premier le premier et le deuxième dispositifs d'acquisition de données calculé selon la relation :

$$TOF' = \frac{1}{2}(t_{A2} - t_{A1} - T)$$

Dans un mode de réalisation possible, le procédé comprend en outre un horodatage des évènements haute fréquence détectés par le premier dispositif d'acquisition de données lors d'une première phase passive d'acquisition de données, via le premier moyen d'horodatage local, et des évènements haute fréquence détectés par le deuxième dispositif d'acquisition de données lors d'une deuxième phase passive d'acquisition de données, via le deuxième moyen d'horodatage local.

La première phase passive d'acquisition de données est déclenchée de préférence au deuxième instant de réception $t_{A2}$ horodaté par le premier moyen d'horodatage local.

La deuxième phase passive d'acquisition de données est déclenchée de préférence au deuxième instant d'injection $t_{B2}$ horodaté par le deuxième moyen d'horodatage local.

La première phase passive d'acquisition de données et la deuxième phase passive d'acquisition de données peuvent être avantageusement réalisées sur une fenêtre temporelle de même durée prédéterminée.

Dans un mode de réalisation possible, le premier évènement haute fréquence détecté par le premier dispositif d'acquisition de données et le deuxième évènement haute fréquence détecté par le deuxième dispositif de données correspondent à deux signaux générés par une même décharge partielle en un point du réseau situé entre le premier et le deuxième dispositifs d'acquisition de données, et le procédé comporte en outre une étape de calcul de la localisation $Z_{PD}$ de la décharge partielle selon la relation

$$Z_{PD} = \frac{TOF' - \Delta t_{oa}}{2TOF'} . l_c$$

dans laquelle $l_c$ est une longueur de câble entre le premier et le deuxième dispositifs d'acquisition de données. Notamment, en particulier dans la relation ci-dessus, $\Delta t_{oa}$ désigne la différence entre l'instant d'arrivée de la décharge partielle au premier dispositif d'acquisition de données horodaté par le premier moyen d'horodatage local et l'instant d'arrivée de la décharge partielle au deuxième dispositif d'acquisition de données horodaté par le deuxième moyen d'horodatage local.

La présente invention a également pour objet un système de surveillance en ligne d'un réseau de distribution électrique comportant au moins un premier et un deuxième dispositif d'acquisition de données, chaque dispositif d'acquisition de données étant localisé en un point connu du réseau et étant configuré pour détecter des évènements haute fréquence lors de phases passives d'acquisition de données et pour injecter des signaux haute fréquence, le système de surveillance en ligne étant caractérisé en ce qu'il comporte un premier moyen d'horodatage local associé au premier dispositif d'acquisition de données, un deuxième moyen d'horodatage local associé au deuxième dispositif d'acquisition de données, et des moyens de synchronisation configurés pour :

- injecter dans le réseau un premier signal comprenant au moins une impulsion haute fréquence à partir du premier dispositif d'acquisition de données à un premier instant d'injection $t_{A1}$ horodaté par le premier moyen d'horodatage local ;

- recevoir ledit premier signal au niveau du deuxième dispositif d'acquisition de données à un premier instant de réception $t_{B1}$ horodaté par le deuxième moyen d'horodatage local ;

- injecter dans le réseau un deuxième signal identique audit premier signal à partir du deuxième dispositif d'acquisition de données, le deuxième signal étant injecté à un deuxième instant d'injection $t_{B2}$ horodaté par le deuxième moyen d'horodatage local et séparé du premier instant de réception $t_{B1}$ par une durée T prédéfinie ;

- recevoir ledit deuxième signal au niveau du premier dispositif d'acquisition de données à un deuxième instant de réception $t_{A2}$ horodaté par le premier moyen d'horodatage local ; et

- déterminer une différence de synchronisation $\Delta t_{oa}$ entre le premier moyen d'horodatage local et le deuxième moyen d'horodatage local sur la base du premier instant d'injection $t_{A1}$, du deuxième instant de réception $t_{A2}$, et de la durée T prédéfinie.

Dans un mode de réalisation possible, le premier moyen d'horodatage local et le deuxième moyen d'horodatage local sont des compteurs N bits, N étant un entier supérieur ou égal à 16.

Dans un mode de réalisation possible, le premier moyen d'horodatage local est intégré au premier dispositif d'acquisition des données, et/ou le deuxième moyen d'horodatage local est intégré au deuxième dispositif d'acquisition des données.

**Brève description des figures**

La description qui va suivre en regard des dessins annexés, donnés à titre d'exemples non limitatifs, fera bien comprendre en quoi consiste l'invention et comment elle peut être réalisée. Sur les figures annexées :

la figure 1, déjà décrite ci-avant, illustre partiellement et schématiquement un exemple de réseau de distribution électrique avec un système de surveillance en ligne comprenant des dispositifs d'acquisition de données synchronisés de manière connue sur la base d'un système de navigation de type GPS;
la figure 2 illustre partiellement et schématiquement un exemple de un réseau de distribution électrique avec des dispositifs d'acquisition de données synchronisés selon un mode de réalisation possible de l'invention;
la figure 3 illustre schématiquement un dispositif d'acquisition de données conforme à un mode de réalisation possible selon l'invention;
la figure 4 illustre des étapes possibles pour un procédé de synchronisation conforme à l'invention ;
la figure 5 illustre schématiquement certaines étapes du procédé de la figure 4.

**Description de mode(s) de réalisation**

Dans les figures, les éléments identiques ou équivalents porteront les mêmes signes de référence. Les différents schémas ne sont pas à l'échelle.

Dans la suite, la synchronisation entre au moins deux dispositifs d'acquisition de données d'un système de surveillance selon l'invention sera décrite dans le cas non limitatif où le système de surveillance en ligne est configuré pour identifier et localiser des décharges partielles dans le réseau. Le principe de synchronisation peut néanmoins être élargi à tout système de surveillance en ligne disposant de plusieurs dispositifs d'acquisition de données qui doivent être synchronisés.

La figure 2 illustre partiellement un réseau de distribution électrique similaire au réseau de la figure 1, comprenant un système de surveillance d'évènements. Le réseau de distribution électrique est par exemple un réseau haute tension ou moyenne tension, composé d'une pluralité de câbles électriques, d'accessoires de connexion ou de raccordement, d'appareillages et/ou de transformateurs. Le système comprend une pluralité de dispositifs 1 d'acquisition placés en différents points connus du réseau, tels que les points A, B et C représentés sur la figure 2. Les points A, B, C où sont localisés les dispositifs d'acquisition de données sont de préférence situés aux extrémités de câbles ou de tronçons de câbles. Dans le cas non limitatif d'un réseau souterrain, les dispositifs 1 d'acquisition de données sont placés de préférence à des endroits faciles d'accès, par exemple au niveau des transformateurs.

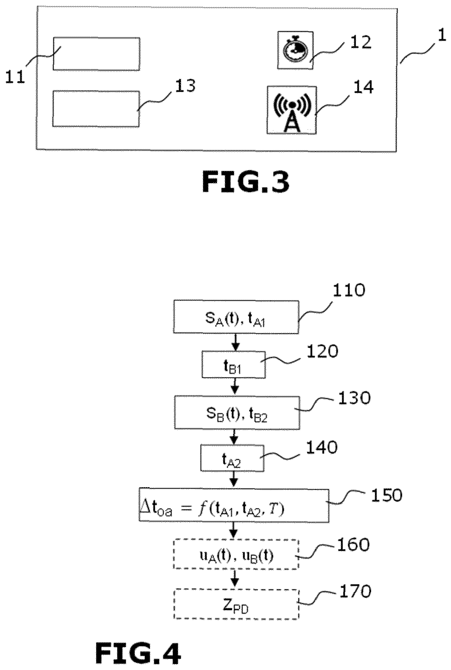

Les dispositifs 1 étant ici dédiés, de façon non limitative, à la détection et la localisation des décharges partielles, chaque dispositif 1 comporte classiquement, comme illustré schématiquement sur la figure 3, des moyens de détection 11 aptes à détecter des évènements impulsionnels occasionnés dans les câbles par les décharges partielles, tels que les impulsions haute fréquence $u_A(t)$ et $u_B(t)$ engendrées par la décharge impulsionnelle 2 de la figure 2. Les moyens 11 sont par exemple un capteur non invasif, de préférence un capteur inductif 11, situé autour du câble au point de localisation du dispositif. En lieu et place du récepteur GPS 10 de la figure 1, le système de surveillance en ligne comporte en outre un moyen d'horodatage local 12 associé à chaque dispositif 1 d'acquisition de données, et des moyens de synchronisation temporelle configurés pour implémenter les étapes d'un procédé de synchronisation conforme à l'invention. Par « associé », on entend que chaque moyen d'horodatage local 12 est soit relié électriquement et fonctionnellement à chaque dispositif 1, soit intégré dans chaque dispositif 1 comme illustré sur la figure 3. Chaque dispositif 1 comporte également des moyens d'injection 13 configurés pour générer des signaux haute fréquence et injecter ces signaux haute fréquence via les moyens de détection 11. Ces moyens d'injection 13 font partie, comme cela apparaîtra plus clairement dans la suite, des moyens de synchronisation temporelle. Chaque dispositif 1 d'acquisition de données peut comporter en outre avantageusement un module 14 de communication mobile (4G ou plus) ou par Ethernet, lui permettant notamment de recevoir voir des signaux de contrôle émis par un serveur distant (non représenté) compris dans le système de surveillance en ligne, ou de transmettre des informations, telles que les données acquises, à ce serveur.

Chaque moyen d'horodatage local 12 est de préférence une horloge locale précise, ou un compteur de 16 bits ou plus. Un tel moyen d'horodatage local 12 permet d'horodater chaque injection d'un signal haute fréquence, chaque réception d'un signal haute fréquence, et chaque évènement détecté par le capteur haute fréquence 11 au point de localisation du dispositif 1 d'acquisition de données, lors d'une phase passive d'acquisition de données.

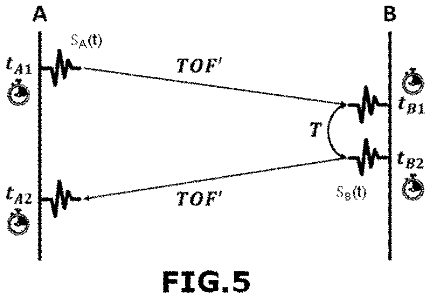

Un procédé de synchronisation temporelle, conforme à la présente invention, entre les dispositifs 1 d'acquisition de données, va à présent être décrit en référence aux figures 4 et 5. Par souci de simplification, l'explication est faite en ce qui concerne les deux dispositifs 1 localisés aux points A et B, mais peut aisément être étendue à tous les dispositifs d'acquisition de données 1 présents dans le système de surveillance en ligne du réseau électrique. Dans la suite, on appelle « premier dispositif d'acquisition de données » le dispositif 1 placé au point A, et « deuxième dispositif d'acquisition de données » le dispositif 1 placé au point B. Les deux dispositifs étant identiques, leur rôle peut néanmoins être inversé :

Le procédé de synchronisation débute par une étape 110 lors de laquelle le premier dispositif 1 d'acquisition de données génère un premier signal $S_A(t)$, et injecte ce premier signal dans le réseau, plus précisément dans le câble. Ce premier signal $S_A(t)$, généré ou délivré par les moyens d'injection 13 du premier dispositif 1, comprend au moins une impulsion haute fréquence. Il est ainsi possible d'injecter ce premier signal dans le réseau au point A, en utilisant les moyens de détection 11 dans un mode actif (par opposition au mode passif dans lequel les moyens de détections 11 reçoivent des signaux). Dans un mode de réalisation possible, ce premier signal $S_A(t)$ correspond à une séquence d'impulsions haute fréquence de période prédéterminée. L'utilisation de plusieurs impulsions successives, au lieu d'une unique impulsion, améliore avantageusement la résolution des signaux et pallie les effets d'atténuation et de dispersion du signal lors de sa propagation dans le câble. L'instant d'injection $t_{A1}$ de ce premier signal est horodaté par le moyen d'horodatage local 12 intégré, ou plus largement associé, au premier dispositif 1, et enregistré localement ou transmis pour enregistrement au serveur central via le module de communication 14 du premier dispositif 1.

Le premier signal injecté se propage dans les différents composants du réseau (câbles et transformateurs et/ou appareillages de commutation, et/ou jonctions de câbles, etc.) jusqu'à atteindre le deuxième dispositif 1 d'acquisition de données. Ce premier signal $S_A(t)$ est donc reçu par le deuxième dispositif 1 lors d'une étape 120 via ses moyens de détection 11. L'instant de réception $t_{B1}$ de ce premier signal est horodaté par le moyen d'horodatage local 12 intégré, ou plus largement associé, au deuxième dispositif 1, et enregistré localement.

Après une durée T prédéfinie suivant l'instant de réception $t_{B1}$, le deuxième dispositif 1 d'acquisition de données génère un deuxième signal $S_B(t)$, identique au premier signal, et injecte ce deuxième signal au point B du réseau, plus précisément dans le câble, en utilisant ses moyens de détection 11 dans un mode actif (étape 130 sur les figures 4 et 5). L'instant d'injection $t_{B2}$ de ce deuxième signal $S_B(t)$ est horodaté par le moyen d'horodatage local 12 intégré, ou plus largement associé, au deuxième dispositif 1, et enregistré localement. La durée T prédéfinie séparant l'instant de réception $t_{B1}$ et l'instant d'injection $t_{B2}$ de ce deuxième signal $S_B(t)$ est choisie de préférence supérieure à au moins une valeur estimée de temps de vol d'un signal entre le premier et le deuxième dispositifs 1 d'acquisition de données. Dans le cas où le premier signal et le deuxième signal correspondent à une séquence d'impulsions périodiques haute fréquence de période prédéfinie $T_{A/B}$, la durée T prédéfinie est choisie de préférence supérieure à la somme de la valeur estimée de temps de vol et de ladite période prédéfinie $T_{A/B}$. La valeur estimée de temps de vol au travers du réseau n'a pas besoin d'être précise. Il peut s'agir d'une valeur moyenne de temps de vol au travers des composants du réseau.

Ce deuxième signal injecté $S_B(t)$ se propage dans les différents composants du réseau (câbles et transformateurs et/ou appareillages de commutation, et/ou jonctions de câbles, etc.) en subissant les mêmes effets que ceux rencontrés lors de la propagation du premier signal $S_B(t)$, jusqu'à atteindre le premier dispositif 1 d'acquisition de données. Ce deuxième signal $S_B(t)$ est donc reçu par le premier dispositif 1 lors d'une étape 140 via ses moyens de détection 11. L'instant de réception $t_{A2}$ de ce deuxième signal est horodaté par le moyen d'horodatage local 12 intégré, ou plus largement associé, au premier dispositif 1, et enregistré localement ou transmis pour enregistrement au serveur central via le module de communication 14 du premier dispositif 1.

Il est alors possible, lors d'une étape 150, de déterminer une différence de synchronisation $\Delta t_{oa}$ entre le premier moyen d'horodatage local 2 et le deuxième moyen d'horodatage local 12 des deux dispositifs 1 d'acquisition de données sur la base du premier instant d'injection $t_{A1}$, du deuxième instant de réception $t_{A2}$, et de la durée T prédéfinie. Plus précisément, la différence de synchronisation $\Delta t_{oa}$ est déterminée par le calcul selon la relation suivante :

$$\Delta t_{oa} = t_{A2} + TOF'$$

dans laquelle TOF' correspond au temps de vol d'un signal entre le premier le premier et le deuxième dispositifs (1) d'acquisition de données calculé selon la relation :

$$TOF' = \frac{1}{2}(t_{A2} - t_{A1} - T)$$

Ce calcul peut être effectué en local (au niveau du premier dispositif 1) ou centralisé au niveau du serveur distant.

Tout évènement haute fréquence susceptible d'être détecté par les moyens de détection 11 du premier dispositif 1 ou du deuxième dispositif 1 lors de phases passives d'acquisition de données vont par suite pouvoir être horodatés d'abord localement, via les moyens d'horodatage locaux 12, puis dans une base de référence commune grâce à la connaissance de la différence de synchronisation $\Delta t_{oa}$ entre les deux dispositifs 1 d'acquisition de données.

Dans le cas non limitatif où les dispositifs 1 d'acquisition de données sont dédiés à la détection d'évènements haute fréquence correspondants à des signaux $u_A(t)$ et $u_B(t)$ générés par une même décharge partielle 2, le procédé comporte donc le déclenchement d'une première phase passive et d'une deuxième phase passive de détection de ces évènements au niveau respectivement du premier dispositif 1 d'acquisition de données et du deuxième dispositif 1 d'acquisition de données, pendant une fenêtre temporelle de même durée prédéterminée pour les deux phases (étape 160).

Dans un mode de réalisation possible, la première phase passive d'acquisition de données est déclenchée au deuxième instant de réception $t_{A2}$ et la deuxième phase passive d'acquisition de données est déclenchée au deuxième instant d'injection $t_{B2}$. Sur détection des signaux $u_A(t)$ et $u_B(t)$, il est alors possible de calculer la localisation $Z_{PD}$ de la décharge partielle selon la relation

$$Z_{PD} = \frac{TOF' - \Delta t_{oa}}{2TOF'} \cdot l_c$$

dans laquelle $l_c$ est une longueur de câble entre le premier et le deuxième dispositifs 1 d'acquisition de données. Cette étape de calcul 170 peut par exemple être réalisée au niveau du serveur central distant. Notamment, en particulier dans la relation ci-dessus, $\Delta t_{oa}$ désigne la différence entre l'instant d'arrivée de la décharge partielle 2 au premier dispositif 1 d'acquisition de données horodaté par le premier moyen d'horodatage local 12 et l'instant d'arrivée de la décharge partielle 2 au deuxième dispositif 1 d'acquisition de données horodaté par le deuxième moyen d'horodatage local 12.

Les étapes 110 à 150 sont de préférence répétées périodiquement (par exemple une ou plusieurs fois par jour) de manière à compenser les dérives pouvant affecter le réseau, telles que des changements de températures, des surcharges, et/ou une dispersion dans les compteurs 12.

## Revendications

**1.** Procédé de synchronisation entre au moins un premier dispositif (1) et un deuxième dispositif (1) d'acquisition de données d'un système de surveillance en ligne d'un réseau de distribution électrique, chaque dispositif (1) d'acquisition de données étant localisé en un point connu du réseau et étant configuré pour détecter des évènements haute fréquence lors de phases passives d'acquisition de données et pour injecter des signaux haute fréquence, le procédé comportant les étapes suivantes :

- injecter (110) dans le réseau un premier signal comprenant au moins une impulsion haute fréquence à partir du premier dispositif (1) d'acquisition de données à un premier instant d'injection $t_{A1}$ horodaté par un premier moyen d'horodatage local (12) ;
- recevoir (120) ledit premier signal au niveau du deuxième dispositif (1) d'acquisition de données à un premier instant de réception $t_{B1}$ horodaté par un deuxième moyen d'horodatage local (12) ;
- injecter (130) dans le réseau un deuxième signal identique audit premier signal à partir du deuxième dispositif (1) d'acquisition de données, le deuxième signal étant injecté à un deuxième instant d'injection $t_{B2}$ horodaté par le deuxième moyen d'horodatage local (12) et séparé du premier instant de réception $t_{B1}$ par une durée T prédéfinie ;
- recevoir (140) ledit deuxième signal au niveau du premier dispositif (1) d'acquisition de données à un deuxième instant de réception $t_{A2}$ horodaté par le premier moyen d'horodatage local (12) ; et
- déterminer (150) une différence de synchronisation $\Delta t_{oa}$ entre le premier moyen d'horodatage local (12) et le deuxième moyen d'horodatage local (12) sur la base du premier instant d'injection $t_{A1}$, du deuxième instant de réception $t_{A2}$, et de la durée T prédéfinie.

**2.** Procédé selon la revendication 1, dans lequel ladite durée T prédéfinie est supérieure à au moins une valeur estimée de temps de vol d'un signal entre le premier et le deuxième dispositifs (1) d'acquisition de données.

**3.** Procédé selon l'une quelconque des revendications précédentes, dans lequel ledit premier signal injecté et ledit deuxième signal injecté comprennent une séquence d'impulsions haute fréquence de période prédéfinie.

**4.** Procédé selon les revendications 2 et 3, dans lequel ladite durée T prédéfinie est supérieure à la somme de la valeur estimée de temps de vol et de ladite période prédéfinie.

**5.** Procédé selon l'une quelconque des revendications précédentes, dans lequel la différence de synchronisation $\Delta t_{oa}$ est déterminée selon la relation suivante :

$$\Delta t_{oa} = t_{A2} + TOF'$$

dans laquelle TOF' correspond au temps de vol d'un signal entre le premier le premier et le deuxième dispositifs (1) d'acquisition de données calculé selon la relation :

$$TOF' = \frac{1}{2}(t_{A2} - t_{A1} - T)$$

**6.** Procédé selon l'une quelconque des revendications précédentes, comprenant en outre un horodatage (160) des évènements haute fréquence détectés par le premier dispositif (1) d'acquisition de données lors d'une première phase passive d'acquisition de données, via le premier moyen d'horodatage local (12), et des évènements haute fréquence détectés par le deuxième dispositif (1) d'acquisition de données lors d'une deuxième phase passive d'acquisition de données, via le deuxième moyen d'horodatage local (12).

**7.** Procédé la revendication 6, dans lequel la première phase passive d'acquisition de données est déclenchée au deuxième instant de réception $t_{A2}$ horodaté par le premier moyen d'horodatage local (12).

**8.** Procédé selon les revendications 6 et 7, dans lequel la deuxième phase passive d'acquisition de données est déclenchée au deuxième instant d'injection $t_{B2}$ horodaté par le deuxième moyen d'horodatage local (12).

**9.** Procédé selon l'une quelconque des revendications 6 à 8, dans lequel la première phase passive d'acquisition de données et la deuxième phase passive d'acquisition de données sont réalisées sur une fenêtre temporelle de même durée prédéterminée.

**10.** Procédé selon l'une quelconque des revendications 6 à 9, **caractérisé en ce que** le premier évènement haute fréquence détecté par le premier dispositif (1) d'acquisition de données et le deuxième évènement haute fréquence détecté par le deuxième dispositif (1) de données correspondent à deux signaux générés par une même décharge partielle (2) en un point du réseau situé entre le premier et le deuxième dispositifs (1) d'acquisition de données, et **en ce que** le procédé comporte en outre une étape (170) de calcul de la localisation $Z_{PD}$ de la décharge partielle selon la relation

$$Z_{PD} = \frac{TOF' - \Delta t_{oa}}{2TOF'} . I_c$$

dans laquelle $I_c$ est une longueur de câble entre le premier et le deuxième dispositifs (1) d'acquisition de données, et
dans laquelle TOF' correspond au temps de vol d'un signal entre le premier le premier et le deuxième dispositifs (1) d'acquisition de données calculé selon la relation :

$$TOF' = \frac{1}{2}(t_{A2} - t_{A1} - T).$$

11. Système de surveillance en ligne d'un réseau de distribution électrique comportant au moins un premier et un deuxième dispositif (1) d'acquisition de données, chaque dispositif (1) d'acquisition de données étant localisé en un point connu du réseau et étant configuré pour détecter des évènements haute fréquence lors de phases passives d'acquisition de données et pour injecter des signaux haute fréquence, le système de surveillance en ligne étant **caractérisé en ce qu'**il comporte un premier moyen d'horodatage local (12) associé au premier dispositif (1) d'acquisition de données, un deuxième moyen d'horodatage local (12) associé au deuxième dispositif (1) d'acquisition de données, et des moyens de synchronisation configurés pour :

   - injecter (110) dans le réseau un premier signal comprenant au moins une impulsion haute fréquence à partir du premier dispositif (1) d'acquisition de données à un premier instant d'injection $t_{A1}$ horodaté par le premier moyen d'horodatage local (12) ;
   - recevoir (120) ledit premier signal au niveau du deuxième dispositif (1) d'acquisition de données à un premier instant de réception $t_{B1}$ horodaté par le deuxième moyen d'horodatage local (12) ;
   - injecter (130) dans le réseau un deuxième signal identique audit premier signal à partir du deuxième dispositif (1) d'acquisition de données, le deuxième signal étant injecté à un deuxième instant d'injection $t_{B2}$ horodaté par le deuxième moyen d'horodatage local (12) et séparé du premier instant de réception $t_{B1}$ par une durée T prédéfinie ;
   - recevoir (140) ledit deuxième signal au niveau du premier dispositif (1) d'acquisition de données à un deuxième instant de réception $t_{A2}$ horodaté par le premier moyen d'horodatage local (12) ; et
   - déterminer (150) une différence de synchronisation $\Delta t_{oa}$ entre le premier moyen (12) d'horodatage local et le deuxième moyen (12) d'horodatage local sur la base du premier instant d'injection $t_{A1}$, du deuxième instant de réception $t_{A2}$, et de la durée T prédéfinie.

12. Système selon la revendication 11, **caractérisé en ce que** le premier moyen d'horodatage local (12) et le deuxième moyen d'horodatage local sont des compteurs N bits, N étant un entier supérieur ou égal à 16.

13. Système selon l'une quelconque des revendications 11 et 12, dans lequel le premier moyen d'horodatage local (12) est intégré au premier dispositif (1) d'acquisition des données, et/ou le deuxième moyen d'horodatage local (12) est intégré au deuxième dispositif (1) d'acquisition des données.

FIG.1 (art antérieur)

FIG.2

**FIG.3**

$$S_A(t), t_{A1} \quad 110$$

$$t_{B1} \quad 120$$

$$S_B(t), t_{B2} \quad 130$$

$$t_{A2} \quad 140$$

$$\Delta t_{oa} = f(t_{A1}, t_{A2}, T) \quad 150$$

$$u_A(t), u_B(t) \quad 160$$

$$Z_{PD} \quad 170$$

**FIG.4**

**FIG.5**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2021138569 A

- WO 2004013642 A2